# EUROPEAN PATENT SPECIFICATION

(11) **EP 0 495 997 B1**
(45) Date of publication and mention of the grant of the patent: **11.03.1998**
(21) Application number: 91914196.0
(22) Date of filing: 07.08.1991
(51) Int. Cl.: H01L 35/34, H01L 35/32

(54) **THERMOCOUPLE**
THERMOELEMENT
THERMOCOUPLE

(30) Priority: 09.08.1990 JP 213366/90; 22.07.1991 JP 181096/91; 23.07.1991 JP 182604/91
(43) Date of publication of application: 29.07.1992
(73) Proprietor: SUMITOMO ELECTRIC INDUSTRIES, LTD., Osaka-shi, Osaka 541 (JP)
(72) Inventor: SAWADA, Kazuo, Osaka Works of Sumitomo, Konohana-ku, Osaka-shi, Osaka 554 (JP); INAZAWA, Shinji, Osaka Works of Sumitomo, Konohana-ku, Osaka-shi, Osaka 554 (JP); YAMADA, Kouichi, Osaka Works of Sumitomo, Konohana-ku, Osaka-shi, Osaka 554 (JP)
(74) Representative: Bockhorni, Josef, Dipl.-Ing.
(86) International application number: JP9101057
(87) International publication number: WO9202960

(56) References cited:
- CH-A- 469 323
- DE-A- 970 487
- DE-A- 1 267 297
- JP-A-58 123 782
- JP-B- 6 041 473
- US-A- 3 332 807
- US-A- 3 833 387
- MEASUREMENT TECHNIQUES vol. 26, no. 12, December 1983, NEW YORK US pages 1014 - 1015 F.YA. GIMEL SHEIN ET AL. 'Boron-Nitride Protective Coating for Tungsten- Rhenium Thermocouples'
- 1988 IEEE SOUTHEASTCON,Knoxville,Tenessee, April 11-13, 1988, 88CH2571-8, pp. 511-514, M.G. DUNCAN et al.:"High Voltage Isolation of Thermocouples for Ion Plating"

## Description

### Field of the Invention

The present invention relates to a thermocouple, which is employed for thermometry.

### Description of the Background Art

In relation to thermocouples, generally known are that comprising a conductor passing through an insulator tube of ceramics, a sheathed thermocouple comprising a thermocouple element passing through a tube of a heat resistant alloy, such as a stainless steel alloy, which is filled up with particulates of a metal oxide such as magnesium oxide, and the like.

The thermocouple which is insulated by an insulator tube of ceramics has disadvantages such as inferior flexibility and bulkiness. When this thermocouple is employed under a high vacuum, the insulator adsorbs a large amount of gases since the same is essentially porous and has a large surface area.

In the sheathed thermocouple which is formed by a heat resistant alloy tube and a thermocouple element, on the other hand, the outer diameter is increased and the ends are hard to process.

The document DE-B-1 267 297 discloses a method of producing insulating layers on the surface of thermocouple elements. This method includes the coating of the layer by a plasma torch, which is different to the method used in the present invention.

The US-patent US-A-3 833 387 teaches ceramic coating of high-thermal expansion coefficient for thermo-electric material, wherein the coating suspension is performed by brushing, dipping and spraying. This method does not use a thermocouple as a cathode.

The document "Measurement Techniques", vol. 26, No. 12, December 1983, New York, USA, pages 1014 to 1015 teaches thermo-physical measurements of boron-nitride protective coating for tungsten-rhenium thermocouples. In this document tungsten-rhenium thermocouples are coated with borazol, but does not include a first layer consisting of a metal oxide.

The German Patent DE-C-970 487 discloses an apparatus for measuring high temperatures being a thermocouple element with different non-metallic oxides as a coating layer. This document does not suggest first a thermocouple element with the first layer consisting of a metal oxide and a second layer consisting of a ceramic compound and second the method for producing this thermocouple as in the present invention.

The thermocouple mentioned in the Swiss Patent CH-A-469 323 does also not comprise a first layer consisting of a metal oxide and a second layer consisting of an insulating ceramic compound.

### Disclosure of the invention

An object of the present invention is to provide a method of producing a thermocouple which is compact with a thin insulating layer, excellent in flexibility and provided with no gas adsorption source.

The method of producing the thermocouple according to the present invention as claimed yields a thermocouple element which is coated with a metal oxide layer.

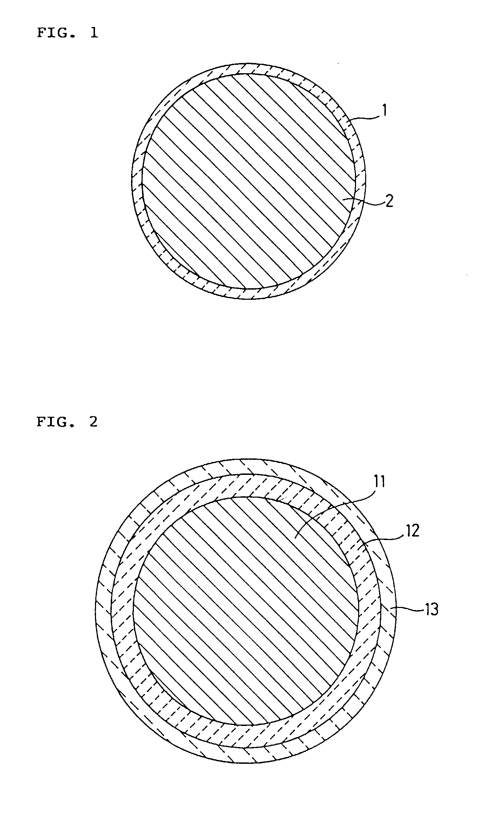

Fig. 1 illustrates a thermocouple comprising a thermocouple element 1 which is coated with a metal oxide layer 2 according to the present invention.

According to the present invention, the metal oxide layer is formed by preparing a sol, in which precursor particulates of a metal oxide are dispersed, by a sol-gel method, dipping a thermocouple element in this sol, supplying the thermocouple element as a cathode thereby bonding the precursor particulates of the metal oxide thereto, and heat treating the same.

According to the present invention as claimed, it is possible to add organic compound salt and/or inorganic salt of a metal, in order to increase the dielectric constant of the sol dispersion medium.

According to the present invention as claimed, the sol for dipping the thermocouple element is preferably prepared by hydrolytic reaction and condensation reaction of metal alkoxide or metal carboxylic ester corresponding to the metal oxide.

The metal oxide preferably contains at least one of compounds selected from a group of silicon oxide, aluminum oxide, zirconium oxide and magnesium oxide.

The sol for dipping the thermocouple element can contain ceramics powder. Such ceramics powder is preferably at least one of compounds selected from mica powder, silicon oxide, silicon nitride, silicon carbide, aluminum oxide, boron nitride and aluminum nitride.

According to the present invention, a metal-organic oligomer or a metal-organic monomer for forming an insulating ceramics layer preferably contains silica, alumina, zirconia, silicon nitride, silicon carbide, aluminum nitride, or a mixture thereof, or partially stabilized zirconia.

According to the present invention, the surface of the thermocouple element is preferably oxidized by heating. Due to such oxidation treatment, it is possible to improve adhesion of the metal oxide layer to the thermocouple element.

In a first preferred mode of the present invention, an insulating ceramics layer is further provided on the outer side of the metal oxide layer. The insulating ceramics layer is formed by heating and decomposing at least one of a metal-organic polymer, a metal-organic oligomer and a metal-organic monomer.

In the first mode, the insulating ceramics layer is preferably formed by repeating a process of applying and firing a solution of proper concentration containing at least one of a metal-organic polymer, a metal-organic oligomer and a metal-organic monomer. Namely, it is preferable to reduce the thickness of a film formed by a single application and firing process, for stacking thin films. Such thin films are so stacked that, even if the surface of the metal oxide layer is significantly cracked or irregularized, the insulating ceramics layer can permeate such cracks or irregular portions to smooth the same. Thus, the insulating ceramics layer may be formed to be impregnated into the metal oxide layer.

Fig. 2 is a sectional view illustrating an embodiment according to the first mode of the present invention. Referring to Fig. 2, a metal oxide layer 12 is provided around a thermocouple element 11. Further, an insulating ceramics layer 13 is provided around the metal oxide layer 12.

In a second preferred mode of the present invention, a heat resistant organic resin layer is further provided on the outer side of the metal oxide layer. The heat resistant organic resin layer is preferably prepared from a compound selected from a group of polyimide, polyamideimide and silicon resin. This heat resistant organic resin layer serves as an effective protective layer for the metal oxide layer under environment of not more than about 300°C, to improve flexibility as well as wear resistance.

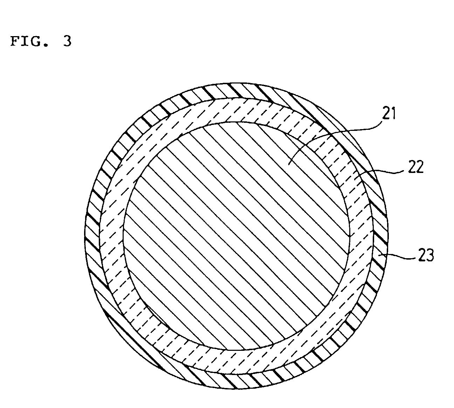

Fig. 3 is a sectional view illustrating an embodiment according to the second mode. Referring to Fig. 3, a metal oxide layer 22 is provided around a thermocouple element 21. A heat resistant organic resin layer 23 is provided around the metal oxide layer 22.

A thermocouple is a thermometry technique utilizing thermoelectromotive force caused by a Seebeck effect, while the value of this thermoelectromotive force results from the compositions of two types of metals which are in contact with each other. Therefore, it is impossible to form a stainless steel alloy or the like, to which ceramics is easily bonded as described in Japanese Patent Application No. 1-322326, on the surface of a thermocouple element.

According to the present invention, a thermocouple element is dipped in a sol in which precursor particulates of a metal oxide are dispersed, and the thermocouple element is energized as a cathode, thereby electrophoresing the precursor particulates of the metal oxide so that the same are electrically deposited on the surface of the thermocouple element.

According to the present invention, further, it is possible to add organic compound salt and/or inorganic salt, in order to improve electrophoretic efficiency of the sol. Thus, the electrophoretic efficiency is so improved that the precursor particulates of the metal oxide can be bonded to the surface of the thermocouple element under a lower applied voltage and/or in a shorter energization time. Consequently, it is possible to form a thick ceramics coating.

Organic compound salt for improving the dielectric constant of such a dispersion medium is prepared from organic ammonium salt which is employed as an interphase moving catalyst. Organic salt of a metal can be prepared from at least one of compounds selected from nitrates, sulfates, chlorides and hydroxides of aluminum, magnesium, potassium and zirconium.

In order to obtain a large film thickness, fine powder of ceramics may be mixed into the sol of the precursor of the metal oxide. Such ceramics fine powder can be prepared from at least one of compounds selected from a group of mica powder, silicon oxide, silicon nitride, silicon carbide, silicon oxide and aluminum nitride.

In the aforementioned first mode, an insulating ceramics layer is further provided on the outer side of the as-formed metal oxide layer. Such an insulating ceramics layer is formed by heating and decomposing at least one of a metal-organic polymer, a metal-organic oligomer and a metal-organic monomer. Even if cracks or irregular portions are present on the surface of the metal oxide layer, therefore, it is possible to smooth the surface of the thermocouple by the insulating ceramics layer which is provided thereon. Due to such smoothing, it is possible to reduce the surface area as well as to reduce gas adsorption sources. Therefore, the thermocouple according to this mode is suitable particularly for application under an ultrahigh vacuum or the like.

According to the present invention, it is possible to reduce the thickness of the insulating film since high insulability can be attained even if the thickness is reduced. Thus, it is possible to attain excellent flexibility.

In the aforementioned second mode, the heat resistant organic resin layer which is excellent in flexibility covers the metal oxide layer, whereby the thermocouple can be further improved in flexibility as a whole.

### Brief Description of the Drawings

Fig. 1 is a sectional view illustrating an embodiment of the present invention.

Fig. 2 is a sectional view illustrating another embodiment of the present invention.

Fig. 3 is a sectional view illustrating still another embodiment of the present invention.

### Best Modes for Carrying Out the Invention

### Example 1

Respective thermocouple elements of a plus leg (alloy mainly composed of nickel and chromium) and a minus leg (alloy mainly composed of nickel) for a K type thermocouple of 1.0 mm in diameter were first heat treated in the atmosphere at 900°C for 15 minutes.

Nitric acid was added to a mixed solution containing 4 mole percent of tetraethylorthosilicate, 40 mole percent of water and 56 mole percent of ethyl alcohol by an amount of 1/100 with respect to the molar rate of tetraethylorthosilicate and reacted at a temperature of 80°C for 2 hours, thereby preparing a sol. 10 mg of aluminum nitrate six hydrate was added to 100 ml of such a sol solution under the room temperature.

The aforementioned thermocouple elements were dipped in the sol prepared in the above manner, and a DC voltage of 200 V was applied thereto for 5 seconds. When the thermocouple elements were taken out from the sol, white films of about 10 µm were formed on the surfaces of the thermocouple elements as gels.

The respective thermocouple elements of the plus and minus legs thus coated with the gels were heated at 670°C for 10 minutes. After the heating, it was recognized that silicon-alumina composite films of 2 µm in thickness were formed.

Ends of the respective thermocouple elements of the plus and minus legs obtained in the aforementioned manner were melted and bonded to each other to form a thermocouple, which in turn attained excellent results up to 700°C.

Examples further provided with insulating ceramics layers on the outer sides of metal oxide layers are now described.

### Example 2

Respective thermocouple elements of a plus leg (alloy mainly composed of nickel and chromium) and a minus leg (alloy mainly composed of nickel) for a K type thermocouple of 0.65 mm in diameter were heat treated in the atmosphere at 800°C for 15 minutes.

Then, a mixed solution of 5 mole percent containing tetrabutoxy zirconium, 8 mole percent of water, 10 mole percent of glacial acetic acid and 77 mole percent of butyl alcohol was prepared, and further stirred under the room temperature for 2 hours, to prepare a sol solution. 2 g of yttrium nitrate six hydrate was added to 100 ml of this sol solution under the room temperature.

The aforementioned thermocouple elements were dipped in the sol prepared in the above manner, and a DC voltage of 200 V was applied thereto for 30 seconds. As the result, white films of about 20 µm were formed on the surfaces of the thermocouple elements as gels.

The respective thermocouple elements of the plus and minus legs thus coated with the gels were heated at 900°C for 10 minutes, and thereafter furnace-cooled. After the cooling, it was recognized that yttria-partially stabilized zirconia films of 2 µm in thickness were formed.

Then, 40 g of 1,1,1,3,3,3,-hexamethyldisilazane and 15 g of trichlorosilane were mixed under a nitrogen jet and stirred at 70°C for 5 hours. Further, distillation was performed at 160°C to distil and remove byproducts. Then, vacuum distillation was performed at 120°C under 5 mmHg to completely remove the byproducts, thereby obtaining polysilazane of 5 g.

The byproducts herein referred to are mainly composed of trimethylchlorosilane and oligosilazane. The polysilazane was diluted by 5 times with toluene, thereby obtaining a coating solution containing a ceramics precursor.

The aforementioned thermocouple elements provided with the yttria-partially stabilized zirconia films were dipped in this coating solution. Thus, the outer surfaces of the thermocouple elements were coated with the coating solution, and heated under a nitrogen atmosphere at 700°C for 10 minutes. This coating and heating step was repeated 10 times in total.

Samples of 30 cm in length were collected from the as-obtained thermocouple elements. Platinum foils of 0.02 mm in thickness were closely wound on four portions of about 10 mm in length, which were separated from each other at intervals of about 50 mm, in these samples. An AC voltage of 60 Hz was applied across the conductors and the metal foils, resulting in dielectric breakdown at 500 V. When insulated wires were bent, insulability was maintained even if the same were bent to diameters of 50 mm. These thermocouples were melted and bonded to each other to form a thermocouple, which in turn attained excellent results up to 700°C.

As to the surface states of the thermocouple elements, the center line average height Ra was 0.03 µm and the maximum height Ry was 0.21 µm according to Surface Roughness of ISO468-1982. The measurement was carried out with a surface measurer of DEKTAK 3030 by Sloan Inc., U.S.A., with a stylus diameter of 0.5 µm, a stylus pressure of 10 mg and a reference length of 50 µm, while employing no cut-off filter.

### Example 5

Respective thermocouple elements of a plus leg (alloy mainly composed of nickel and chromium) and a minus leg (alloy mainly composed of nickel) for a CA thermocouple of 0.32 mm in diameter were first heat treated in the atmosphere at 800°C for 15 minutes. Then, a mixed solution of 5 mole percent of tetrabutoxy zirconium, 8 mole percent of water, 10 mole percent of glacial acetic acid and 77 mole percent of butyl alcohol was prepared and further stirred under the room temperature for 2 hours, to prepare a sol solution. 2 g of yttrium nitrate six hydrate was added to 100 ml of this sol solution under the room temperature.

The aforementioned thermocouple elements were dipped in the sol prepared in the above manner and a DC voltage of 200 V was applied thereto for 2 minutes, whereby white films of about 70 µm were formed on the surfaces of the thermocouple elements as gels.

The thermocouple elements of the plus and minus legs thus coated with the gels were heat treated at 900°C for 10 minutes, and thereafter furnace-cooled. After the cooling, it was recognized that yttria-partially stabilized zirconia films of 5 µm in thickness were formed.

Then, a substance obtained by diluting 16 percent by weight of polyimide varnish (Pyre ML) by Du Pont Co. with N-methyl-2-pyrolidone into 5 percent by weight was applied onto the ceramics-coated thermocouple elements. The strands were passed through a furnace of 400°C at 3.5 m/min. and fired, thereby forming polyimide films of 3 µm in thickness.

The as-obtained strands were subjected to measurement of breakdown voltages, the results of which were 1.6 kV. As to flexibility, no cracking was caused in the films even if the obtained thermocouple elements were wound on cylinders of 1 mm in diameter. The results of a unidirectional abrasion test were 502 g and those of a reciprocating system (w = 0.6 kg) were 12 times, showing excellent results also in relation to wear resistance.

Ends of the thermocouple elements of the plus and minus legs were melted and bonded to each other to form a thermocouple, which in turn attained excellent results up to 700°C.

### Example 6

Respective thermocouple elements of a plus leg (alloy mainly composed of nickel and chromium) and a minus leg (alloy mainly composed of nickel) for a CA thermocouple of 0.16 mm in diameter were prepared.

A sol was prepared by dripping nitric acid into a mixed solution containing 4 mole percent of tetraethylorthosilicate, 40 mile percent of water and 56 mole percent of ethyl alcohol by an amount of 1/100 with respect to the molar rate of tetraethylorthosilicate and reacting the same at a temperature of 80°C for 2 hours, and 5 g of mica powder of 14 µm in nominal mean particle diameter was further mixed to prepare an electrolyte.

The aforementioned thermocouple elements were dipped in the sol prepared in the above manner and a DC voltage of 350 V was applied thereto for 2 minutes, whereby white films of about 20 µm were formed on the surfaces of the thermocouple elements as films.

The thermocouple elements of the plus and minus legs thus coated with the gels were heated at 100°C for 1 hour, and thereafter quenched. After the cooling, it was recognized that silicon oxide-mica composite films of 10 µm in thickness were formed.

Then, silicon resin H-19-2 (by Dow Corning Toray Silicon Co., Ltd.) was diluted with xylene, to prepare a 10 percent solution. This silicon resin solution was applied to outer sides of the aforementioned thermocouple elements provided with the silicon oxide-mica composite films, and heated and fired at 300°C for 5 minutes. This coating and heating/firing step was repeated five times, to obtain coating films of 10 µm in thickness.

The as-obtained thermocouple elements were evaluated to recognize breakdown voltages of 1.0 kV, while no cracking was caused in the films even if these strands were wound on cylinders of 1 mm in diameter as to flexibility.

Ends of the thermocouple elements of the plus and minus legs were melted and bonded to each other to form a thermocouple, which in turn attained excellent results up to 700°C.

### Industrial Availability

The thermocouple according to the present invention can be applied to a thermocouple to which heat resistance is required or a thermocouple which is employed under an ultrahigh vacuum.

## Claims

1. A method of producing a thermocouple comprising a thermocouple element and a metal oxide layer, the method for producing a thermocouple comprising following steps:
forming the metal oxide layer on the outer side of said thermocouple element by preparing a sol in which precursor particulates of said metal oxide are dispersed, by a sol-gel method;
dipping that thermocouple element in said sol;
supplying said thermocouple as a cathode for bonding said precursor particulates of said metal oxide thereto by electrophoresis;
and heat treating the metal oxide layer.

2. A method of producing a thermocouple in accordance with claim 1, wherein preparing the sol is performed by including organic compound salt in that sol in order to improve the dielectric constant of the sol dispersion medium.

3. A method of producing a thermocouple in accordance with claim 1, wherein preparing the sol is performed by including inorganic salt of a metal in that sol in order to improve the dielectric constant of the sol dispersion medium.

4. A method of producing a thermocouple in accordance with claim 1, wherein preparing the sol is performed by including ceramics powder in that sol.

5. A method of producing a thermocouple in accordance with claim 1, wherein preparing the sol is performed by hydrolytic reaction and polymerization reaction of metal alkoxide or carboxylic ester of a metal corresponding to said metal oxide.

6. A method of producing a thermocouple in accordance with claim 1, wherein that metal oxide layer is composed of at least one of compounds selected from a group of silicon oxide , aluminum oxide , circonium oxide and magnesium oxide.

7. A method of producing a thermocouple in accordance with claim 4, wherein the ceramics powder is composed of at least one of compounds selected from a group of mica powder, silicon oxide, silicon carbide, silicon nitride, aluminum oxide, boron nitride and aluminum nitride.

8. A method of producing a thermocouple in accordance with claim 1, wherein the surface of the thermocouple element is oxidized by heating before forming the metal oxide layer.

9. A method of producing a thermocouple in accordance with claim 1, further comprising the step of forming an insulating ceramic layer by heating and decomposing at least one of a metal-organic polymer, a metal-organic oligomer and a metal-organic monomer on the outer side of said metal oxide layer.

10. A method of producing a thermocouple in accordance with Claim 9, wherein said metal-organic polymer, metal-organic oligomer or metal-organic monomer is composed of metal alkoxide, metal organic oxide salt, polysilazane, polycarbosilane, or polyborosiloxane.

11. A method of producing a thermocouple in accordance with claim 9, wherein said metal-organic oligomer or metal-organic monomer forming said insulating ceramics layer are composed of silica, alumina, zirconia, silicon nitride, silicon carbide, aluminum nitride, or a mixture thereof, or partially stabilized zirconia.

12. A method of producing a thermocouple in accordance with claim 1, further comprising the step of providing a heat resistance organic resin layer on the outer side of said metal oxide layer.

13. A method of producing a thermocouple in accordance with claim 12, wherein said heat resistant organic resin layer is composed of at least one of compounds selected from a group of polyimide, polyamideimide and silicone resin.

## Patentansprüche

1. Verfahren zur Herstellung eines Thermoelementes, das ein Thermoelementbestandteil und eine Metalloxidschicht umfaßt, wobei das Verfahren zur Herstellung eines Thermoelementes folgende Schritte umfaßt:
Bilden der Metalloxidschicht auf der äußeren Seite des Thermoelementbestandteiles durch Herstellen eines Sol, in welchem Vorläuferpartikel aus dem Metalloxid durch ein Sol-Gel-Verfahren dispergiert sind;
Eintauchen des Thermoelementbestandteiles in den Sol;
Liefern des Thermoelementes als eine Kathode zum damit Verbinden der Vorläuferpartikel aus dem Metalloxid durch Elektrophorese; und
Wärmebehandlung der Metalloxidschicht.

2. Verfahren zur Herstellung eines Thermoelementes nach Anspruch 1, worin die Herstellung des Sols durch Beinhalten von organischem Verbindungssalz in das Sol durchgeführt wird, um die Dielektrizitätskonstante des Soldispersionsmediums zu verbessern.

3. Verfahren zur Herstellung eines Thermoelementes nach Anspruch 1, worin die Herstellung des Sols durch Beinhalten von inorganischem Salz aus einem Metall in das Sol durchgeführt wird, um die Dielektrizitätskonstante des Soldispersionsmediums zu verbessern.

4. Verfahren zur Herstellung eines Thermoelementes nach Anspruch 1, worin die Herstellung des Sols durch Beinhalten von keramischem Pulver in dem Sol durchgeführt wird.

5. Verfahren zur Herstellung eines Thermoelementes nach Anspruch 1, worin die Herstellung des Sols durch hydrolytische Reaktion und Polymerisationsreaktion von Metallalkoxid oder carboxylischem Ester aus einem Metall, das dem Metalloxid entspricht, durchgeführt wird.

6. Verfahren zur Herstellung eines Thermoelementes nach Anspruch 1, worin die Metalloxidschicht aus mindestens einer der Verbindungen, die aus einer Gruppe von Siliziumoxid, Aluminiumoxid, Zirkoniumoxid und Magnesiumoxid ausgewählt wird, zusammengesetzt ist.

7. Verfahren zur Herstellung eines Thermoelementes nach Anspruch 4, worin das keramische Pulver aus mindestens einer der Verbindungen, die aus einer Gruppe von Micapulver, Siliziumoxid, Siliziumcarbid, Siliziumnitrid, Aluminiumoxid, Bornitrid und Aluminiumnitrid ausgewählt wird, zusammengesetzt ist.

8. Verfahren zur Herstellung eines Thermoelementes nach Anspruch 1, worin die Oberfläche des Thermoelementbestandteiles durch Erwärmen oxidiert wird, bevor die Metalloxidschicht gebildet wird.

9. Verfahren zur Herstellung eines Thermoelementes nach Anspruch 1, weiterhin den Schritt des Bildens einer Isolierkeramikschicht durch Erwärmen und Auflösen von mindestens einem aus einem metallorganischen Polymer, einem metallorganischen Oligomer und einem metallorganischen Monomer auf der äußeren Seite der Metalloxidschicht umfaßt.

10. Verfahren zur Herstellung eines Thermoelementes nach Anspruch 9, worin das metallorganische Polymer, das metallorganische Oligomer oder das metallorganische Momomer aus Metallalkoxid, metallorganischem Oxidsalz, Polysilazan, Polycarbosilan oder Polyborosiloxan zusaammengesetzt ist.

11. Verfahren zur Herstellung eines Thermoelementes nach Anspruch 9, worin das metallorganische Oligomer oder das metallorganische Monomer, die die isolierende Keramikschicht bilden, aus Siliziumoxid, Aluminiumoxid, Zirkoniumoxid, Siliziumnitrid, Siliziumcarbid, Aluminiumnitrid oder einem Gemisch davon, oder teilweise stabilisierten Zirkoniumoxid hergestellt sind.

12. Verfahren zur Herstellung eines Thermoelementes nach Anspruch 1, weiterhin den Schritt des Lieferns einer wärmewiderstandsorganischen Harzschicht auf der äußeren Seite der Metalloxidschicht umfassend.

13. Verfahren zur Herstellung eines Thermoelementes nach Anspruch 12, worin die wärmewiderstandsorganische Harzschicht aus mindestens einer der Verbindungen, die aus einer Gruppe von Polyimid, Polyamidimid und Siliziumharz ausgewählt werden, sich zusammensetzt.

## Revendications

1. Procédé pour la production d'un thermocouple comprenant un élément de thermocouple et une couche d'oxyde métallique, le procédé pour la production d'un thermocouple comprenant les étapes suivantes :
formation de la couche d'oxyde métallique sur le côté extérieur de l'élément de thermocouple en préparant une solution colloïdale ou sol dans lequel sont dispersés des éléments particulaires de précurseur de l'oxyde métallique, par un procédé sol-gel ;
immersion de cet élément thermocouple dans le sol ;
mise en place de ce thermocouple comme cathode pour la liaison des matières particulaires de précurseur de l'oxyde métallique par électrophorèse ;
et traitement thermique de la couche d'oxyde métallique.

2. Procédé pour la production d'un thermocouple selon la revendication 1, dans lequel la préparation du sol est réalisée en incorporant un sel de composé organique dans le sol pour améliorer la constante diélectrique du milieu de dispersion de sol.

3. Procédé pour la production d'un thermocouple selon la revendication 1, dans lequel la préparation du sol s'effectue en incorporant un sel minéral d'un métal dans le sol pour améliorer la constante diélectrique du milieu de dispersion de sol.

4. Procédé pour la production d'un thermocouple selon la revendication 1, dans lequel la préparation du sol s'effectue en incorporant de la poudre céramique dans ce sol.

5. Procédé pour la production d'un thermocouple selon la revendication 1, dans lequel la préparation du sol s'effectue par réaction hydrolytique et réaction de polymérisation d'alcoxyde métallique ou d'ester carboxylique d'un métal correspondant à cet oxyde métallique.

6. Procédé pour la production d'un thermocouple selon la revendication 1, dans lequel la couche d'oxyde métallique est composée d'au moins l'un des composés choisis dans un groupe d'oxyde de silicium, d'oxyde d'aluminium, d'oxyde de zirconium et d'oxyde de magnésium.

7. Procédé pour la production d'un thermocouple selon la revendication 4, dans lequel la poudre de céramique est composée d'au moins l'un des composés choisis dans un groupe de poudre de mica, d'oxyde de silicium, carbure de silicium, nitrure de silicium, oxyde d'aluminium, nitrure de bore et nitrure d'aluminium.

8. Procédé pour la production d'un thermocouple selon la revendication 1, dans lequel la surface de l'élément de thermocouple est oxydée par chauffage avant formation de la couche d'oxyde métallique.

9. Procédé pour la production d'un thermocouple selon la revendication 1, comprenant de plus l'étape consistant à former une couche de céramique isolante par chauffage et décomposition d'au moins l'un parmi un polymère organique métallique, un oligomère organique métallique et un monomère organique métallique sur le côté extérieur de la couche d'oxyde métallique.

10. Procédé pour la production d'un thermocouple selon la revendication 9, dans lequel le polymère métallique organique, l'oligomère minéral métallique ou le monomère organique métallique est composé d'alcoxyde métallique, de sel d'oxyde organique métallique, de polysilazane, de polycarbosilane ou de polyborosiloxane.

11. Procédé pour la production d'un thermocouple selon la revendication 9, dans lequel l'oligomère organique métallique ou le monomère organique métallique formant la couche de céramique isolante sont composés de silice, d'alumine, de zircone, de nitrure de silicium, de carbure de silicium, de nitrure d'aluminium ou de leurs mélanges ou partiellement de zircone stabilisé.

12. Procédé pour la production d'un thermocouple selon la revendication 1, comprenant de plus l'étape consistant à mettre en place une couche de résine organique à résistance thermique sur le côté extérieur de la couche d'oxyde métallique.

13. Procédé pour la production d'un thermocouple selon la revendication 12, dans lequel la couche de résine organique résistant à la chaleur est composée d'au moins l'un des composés choisis dans un groupe de polyimide, polyamideimide et résine de silicone.
